# EUROPEAN PATENT SPECIFICATION

(11) **EP 2 489 758 B1**
(45) Date of publication and mention of the grant of the patent: **26.06.2013**
(21) Application number: 12155598.1
(22) Date of filing: 15.02.2012
(51) Int. Cl.: C23C 14/54, C23C 14/02, C23C 14/16, B29C 65/56

(54) **Methods of depositing aluminium layers**
Verfahren zum Auftragen von Aluminiumschichten
Procédés pour le dépôt de couches d'aluminium

(30) Priority: 16.02.2011 GB 201102673
(43) Date of publication of application: 22.08.2012
(73) Proprietor: SPTS Technologies Limited, Newport Gwent NP18 2TA (GB)
(72) Inventor: Hyndman, Rhonda, Co. Londonderry, BT46 5EN (IE); Burgess, Stephen, Ebbw Vale, Gwent NP23 5NA (GB)
(74) Representative: Dunlop, Brian Kenneth Charles

(56) References cited:
- WO-A2-2008/063754
- US-A- 6 107 182
- US-A1- 2007 037 393
- US-B1- 6 242 288

## Description

This invention relates to the deposition of aluminium layers or films on a thin substrate.

In a number of applications, silicon wafers require thick aluminium layers to be deposited on them. For example, when the device being formed from the wafer includes high powered transistors, thick aluminium layers may be necessary as contact layers in order to handle the very high current densities inherent in these devices.

Typically such devices have a vertical architecture with a source contact comprising one or more aluminium layers from 1-20 μm thickness. These are deposited onto the semiconductor device (up to e.g. MOSFET.IGBT Bipolar) imbedded on a full thickness wafer. Typically the drain contact is formed on the back of the wafer. However, as most of the thickness is not useful to the device performance, but rather contributes to series resistance which wastes power, the wafers are ground back from typically 720 μm to < 200 μm thick prior to the deposition of the drain contact. Such thin wafers are fairly flexible and subject to considerable warpage or bowing when under the stress induced by the various deposited layers. It is known that sputtered aluminium layers deposited at temperatures > ∼20°C are tensile due to the mismatch of thermal expansion of the film and underlying substrate. Thus an 8 μm sputter Al film typically has a stress of -60 MPa. Table 1 below sets out the bow that can be induced in wafers of various thicknesses. It will be seen that for a 200 μm Si wafer a bow of approximately ∼2mm can be induced. Such a bow makes the wafer difficult to process in subsequent steps.

**Table 1: Induced Wafer Bow for different thickness Wafers as calculated using Stoney's Equasion**

| **Wafer Thickness** | **Stress** | **Wafer Bow** |
|---|---|---|
| **μm** | **MPa** | **μm** |
| 720 | 60 | 154 |
| 200 | 60 | 1992 |
| 100 | 60 | 7669 |

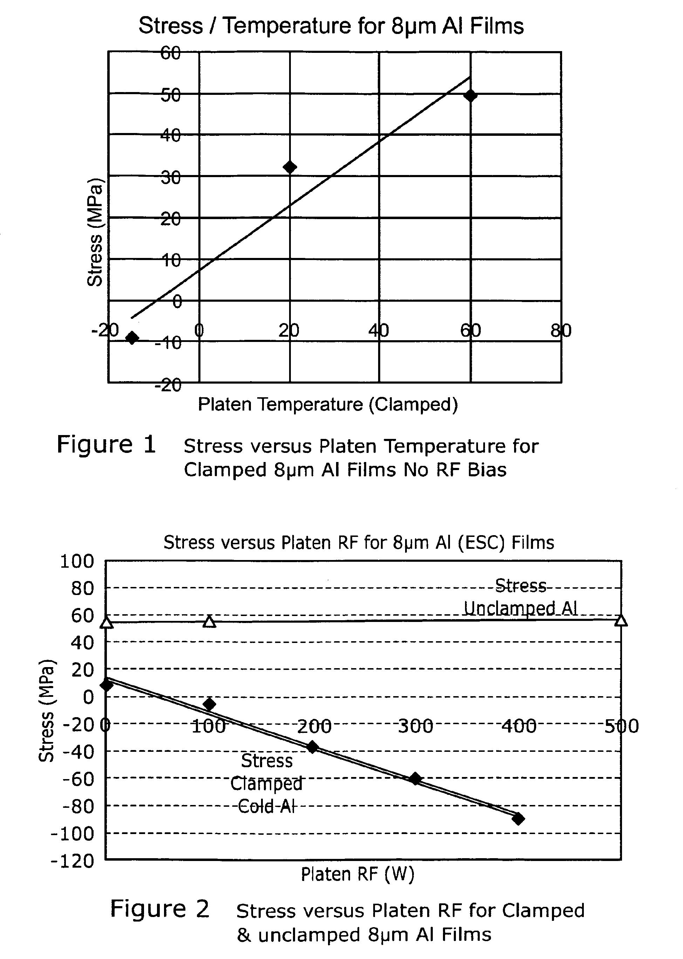

It is known that stress can be reduced to nearly zero by sputtering the film at low temperature with the wafer clamped to a cooled electrostatic chuck. The relationship between stress and platen or chuck temperature for an 8 μm film when there is no RF bias on the platen is shown in Figure 1. It is further known that stress can be made compressive through the addition of RF bias and this is illustrated in Figure 2.

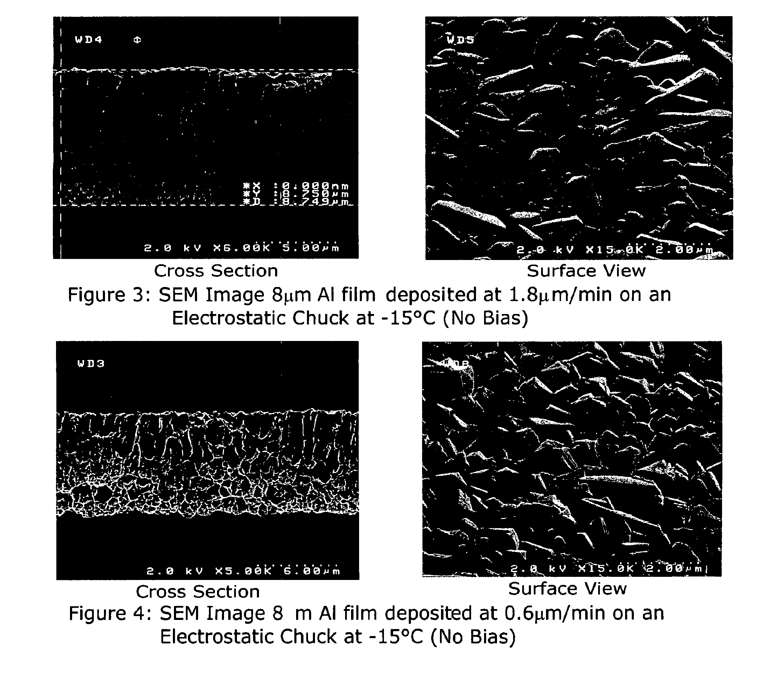

The Applicants have identified, however, that low temperature, clamped aluminium exhibits an unfavourable grain structure comprising a very small columnar grain separated by quite large voids. This structure can be seen clearly in Figures 3 and 4, which are scanning electro micrographs (SEM) of 8μm aluminium films deposited at ∼15°C on an electrostatic chuck (ESC) at two different deposition rates (1.8 μm/min and 0.6 μm/min respectively). It will be readily understood that this rough and voided grain structure can compromise the electromechanical properties of the device leading to a reduction in the device performance. Thus there may be increased resistivity and reduced device lifetimes amongst other disadvantages.

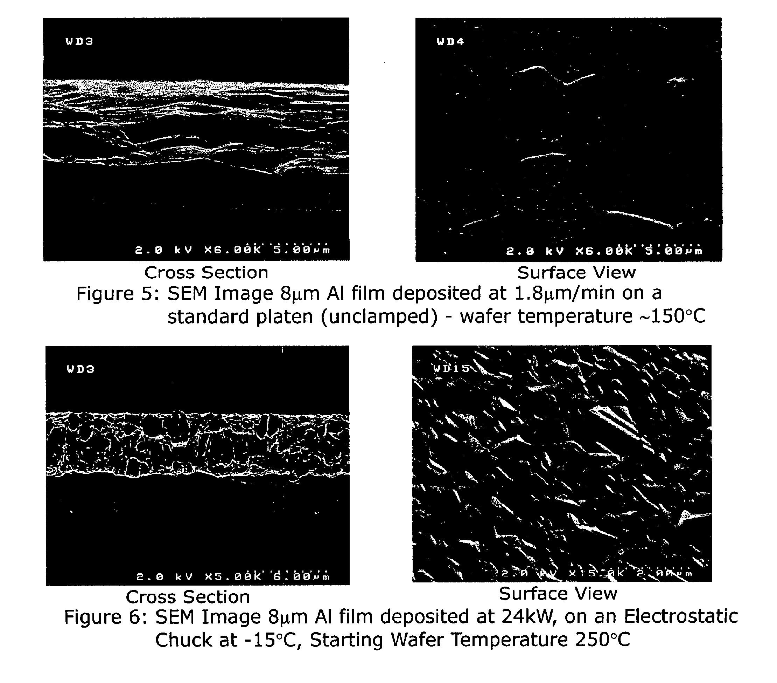

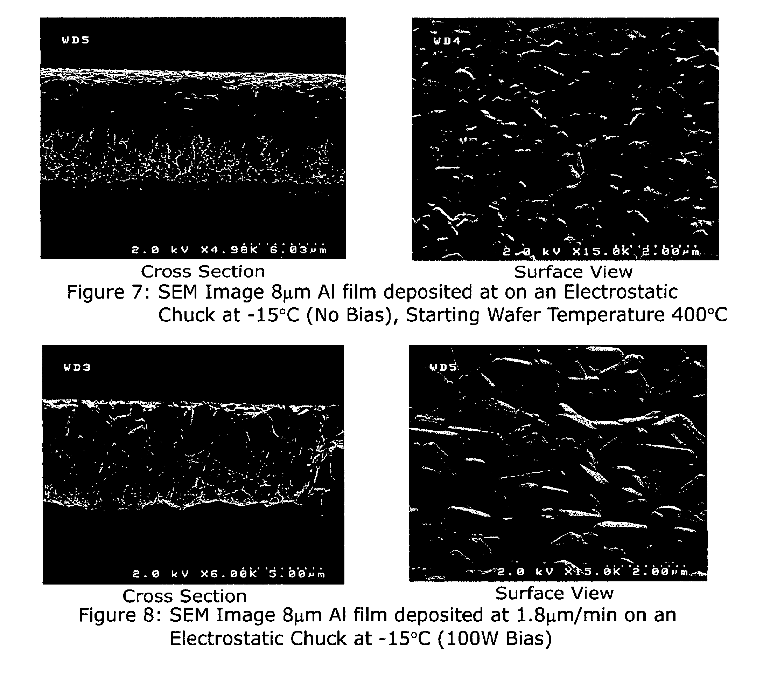

Figure 5 shows a more typical grain structure of an unclamped 8 μm aluminium film. It will be seen that there are large flat hexagonal grains entirely without voids. Attempts have been made to recover the grain structure to some degree by preheating the wafer in a separate module immediately before the Al deposition takes place. However, research has indicated that the starting temperature of the wafer needs to be ~400°C for this to be effective. This is illustrated by the two processes shown in Figures 6 and 7. However, it will be seen that the wafer needs to be heated to around 400°C to substantially get rid of the voids. This temperature is too high to allow stable processing of the underlying structure. Increasing the initial wafer temperature also leads to an increase in tensile stress of the Al film, which therefore becomes more difficult to compensate by bias. The Applicants have therefore determined that this approach does not provide a realistic solution for the problem of improving the aluminium grain structure and maintaining low stress at the same time.

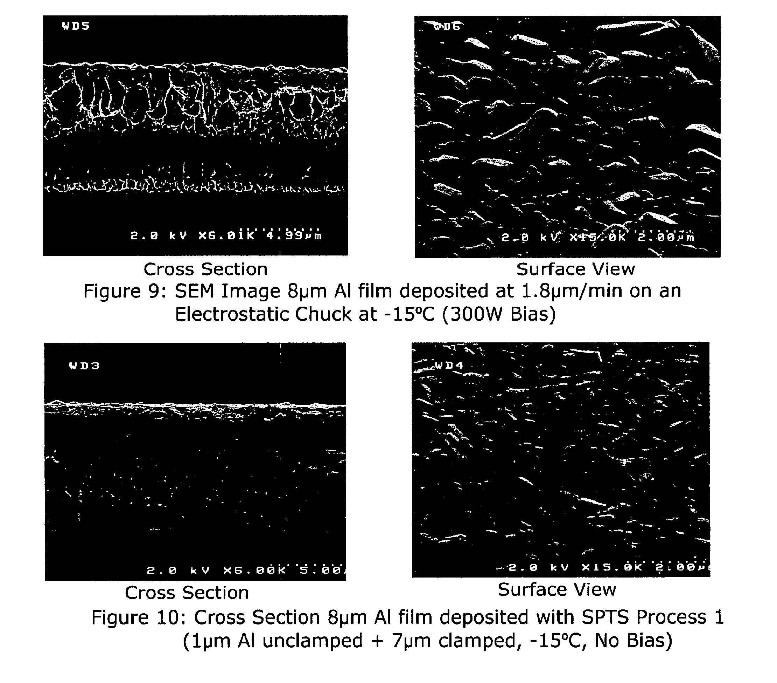

Figures 8 and 9 illustrate that the addition of RF bias to densify the film to some degree. This renders the films compressive as indicated in Figure 2. However, it can be seen that this does not significantly improve the grain structure. The problem of surface roughness and voiding persists up to very high biases.

The Applicants have determined a way of depositing such aluminium and aluminium alloy films, which overcomes or at least mitigates the above problems of excessive stress and poor grain structure.

The invention consists in a method of depositing an aluminium film on a silicon wafer less than 250µm thick Including:
(a) placing the wafer on a support;
(b) sputtering a first layer of aluminium onto the substrate with the substrate in an unclamped condition;
(c) clamping the substrate to the support and depositing a second layer of aluminium continuous with the first layer wherein the second layer Is thicker than the first layer and the second layer Is deposited at a substrate temperature of <22°C.

The method preferably includes providing an RF bias to the support during the clamped part of the method. The RF power may, for example, be between 100 watts and 500 watts.

The first layer may be from about 0.5 µm - to about 2 µm thick. (preferably around 1 µm) and the second layer may be about 7µm thick although greater thickness may be required for some applications.

The deposition steps may occur on different supports (e.g. in different deposition applications or modules) but it is preferred that the deposition steps are performed on the same support, in which case the second deposition step may be continuous with the first and be initiated by the clamping of the substrate. This is particularly readily achieved if the support is an electrostatic chuck.

The aluminium alloy is preferably Al(Cu, Si (wherein the Si consists in less than 5%)).

Although the invention has been defined above it is to be understood it includes any inventive combination of the features set out above or in the following description.

The invention may be performed in various ways and specific embodiments will now be described, by way of example, with reference to the accompanying drawings in which:
Figures 10 to 12 show respective cross sections and surface views of films prepared in accordance with embodiments of the invention;
Figure 13 shows a plot of wafer temperature against deposited film thickness for a 1.8 μm/min Al deposition;
Figure 14 shows cross section and surface SEM of an embodiment of invention in which the wafer is biased;
Figure 15 shows a cross section and surface SEM of an embodiment of the invention with no bias;
Figure 16 is a plot of film reflectivity against platen bias for different deposition processes; and
Figure 17 is a plot illustrating the stress bias curve for an embodiment of the invention.

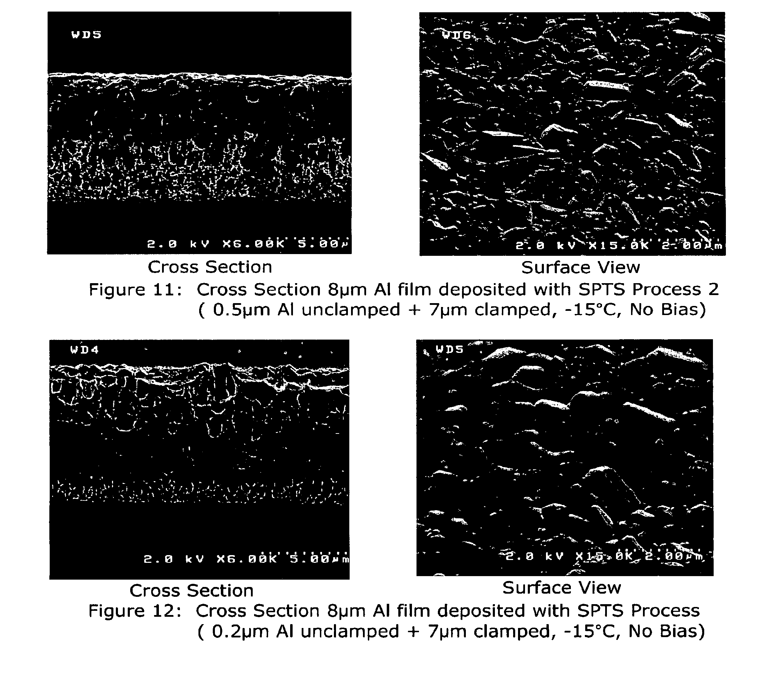

In the light of the issues raised by the prior art deposition processes the inventors seek to achieve an approach the deposition of dense, smooth void free aluminium films with tuneable stress, even at low temperatures. In general they have determined that by depositing an unclamped aluminium seed layer of 0.5 - 2 μm in thickness, prior to clamping the film to complete the deposition at a low ESC platen temperature leads to an acceptable film. Using this technique it has proved possible to suppress the formation of very small columnar grains and improved the structure of the aluminium film, whilst retaining the low tensible stress. This is illustrated in Figures 10 to 11. A thin unclamped aluminium layer acts as a template for the growth of the rest of the film and suppresses the formation of the very small strong columnar grain structure, which is common in a standard clamped low temperature (< 20°c) deposition. It has been found that if the thickness of the unclamped seed layer is reduced to below around 0.5 μm, the columnar grain structure begins to reassert itself and the film becomes once again rough and voided as can be seen in Figure 12, where the thickness of the seed layer is 0.2 μm Al.

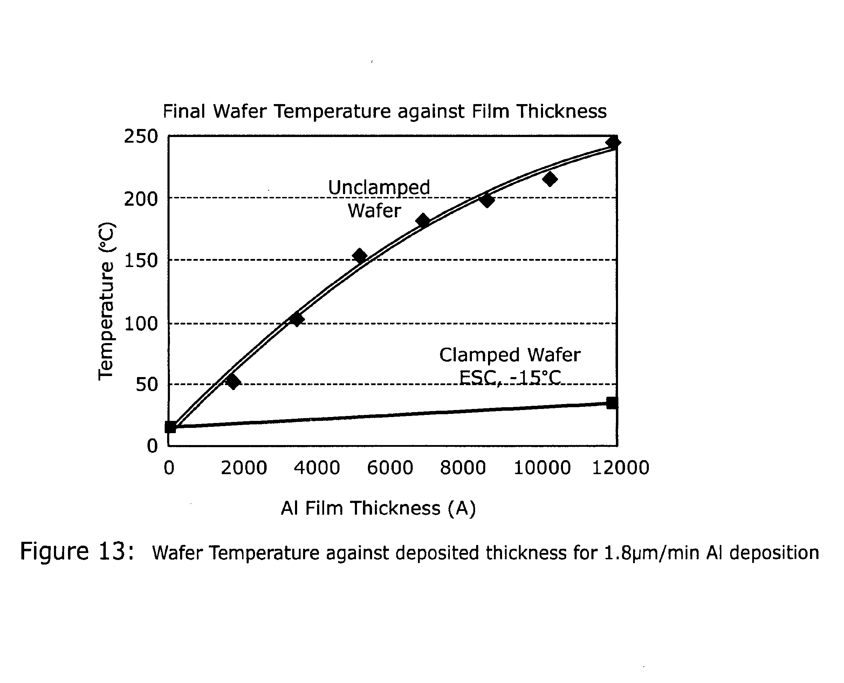

The seed layer may be deposited either in a separate module or in the same module with the electrostatic chuck switched off. The platen temperature at which the unclamped seed layer is deposited is not the driving factor in the structural change. This is because in the case of an unclamped deposition, the wafer temperature can increase to a much higher temperature than the platen, due both to plasma heat and the latent heat of deposition. Figure 13 shows the wafer temperature of an unclamped, full thickness Si wafer under deposition of a 1.8 μm/min aluminium film. The wafer temperature increases to >200°C at the end of 1 μm deposition and may approach ∼350°C at the end of 8 μm deposition. If the wafer is being processed in the same module, it is possible that the electrostatic chuck may be cool from previous cooling.

However, the inherent heat generated by deposition will only usually be removed if the wafer is in good thermal contact with the platen (i.e. it is clamped) and there is some source of active cooling to remove the heat energy from the system. This realisation has enabled the inventors to deposit the seed layer on the same low temperature platen as the rest of the thick aluminium film. As was seen in connection with Figure 7, increasing the initial wafer temperature using a pre-heat station is useful for obtaining better quality but the necessary wafer temperature is generally too high. It is also another processing step, with consequent cost and time implications.

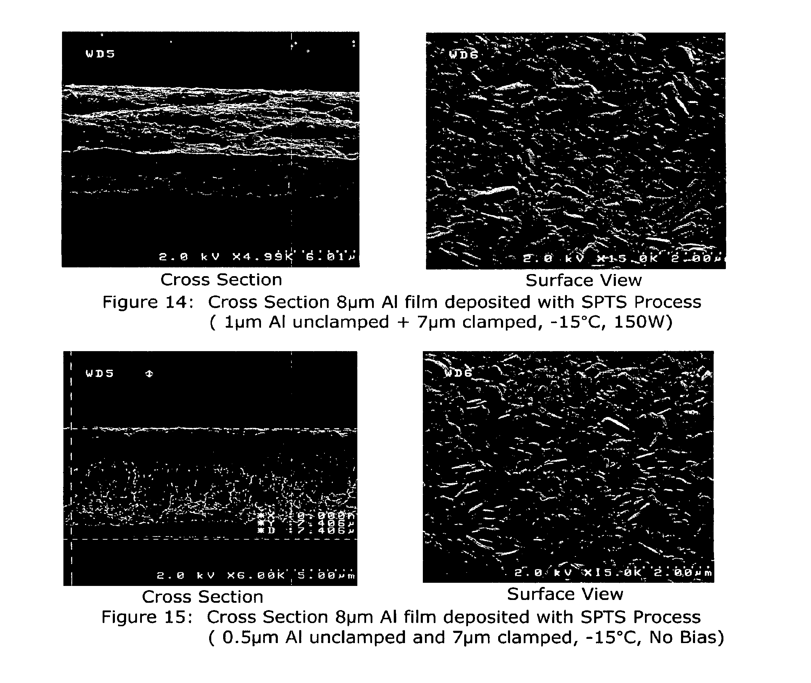

Using the above basic process set out above, stress can still be controlled down to ∼100MPa compressive by applying RF bias during the clamping and at the same time a dense smooth film can be achieved. The affect of bias is illustrated in Figures 14 and 15.

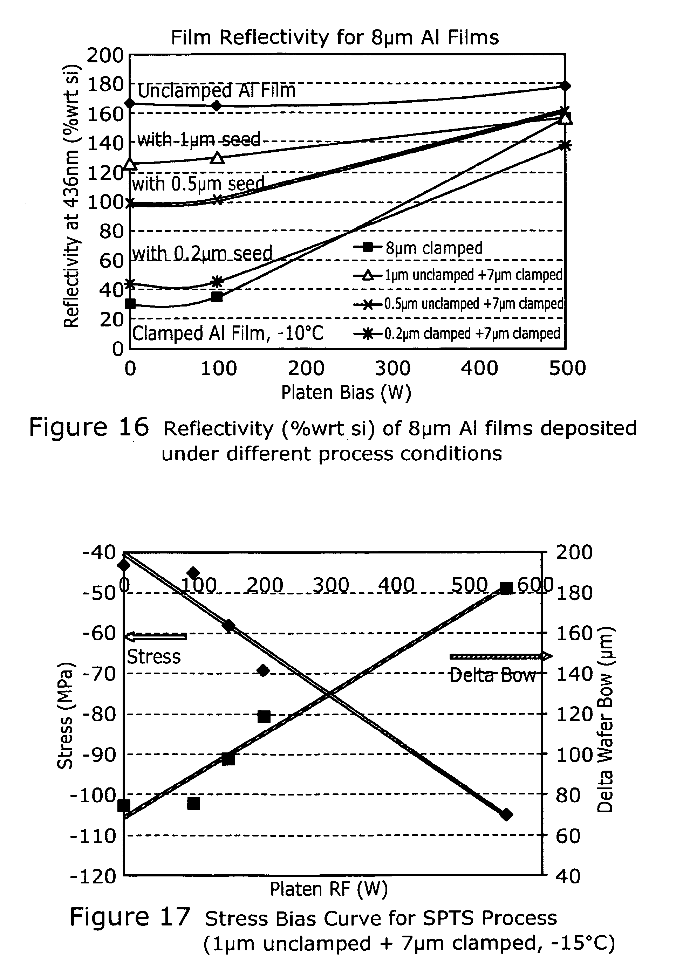

The improvement in the film structure can also be indicated by the film reflectivity. It will be seen in Figure 16 that this increases with the thickness of the unclamped seed layer. The reflectivity measurement is an indicator of surface roughness of aluminium films. It will be noted that the cold clamp films are inherently very rough and show much lower reflectivity compared to a smoother unclamped aluminium film.

Figure 17 shows stress against platen RF for 8 μm Al film deposited using an embodiment of the invented process i.e. 1 μm unclamped seed layer and 7 μm clamped. The tuneable stress range for the new process with an unclamped seed is comparable with that obtained for a standard, cold clamped Al film. However, as discussed previously, a denser void free grain structure is maintained over the whole stress range making this process highly suitable for fabrication of practical semi-conductor devices.

The invention therefore provides a simple method for depositing aluminium at low temperatures in a manner which forms a smooth, dense, void free film with it stressed tuneable from low tensile through to compressive. The process may be formed at deposition temperatures of below 0°c. Stress tuning is achieved over a range down to ∼100MPa compressive while applying RF bias during the clamped deposition step. A favourable grain structure for device fabrication is retained over the entire stress range and with seed layers down to 0.5 μm in thickness. It will be understood that the benefit of improved film using the basic process is advantageous whether or not stress tuning is required.

## Claims

1. A method of depositing an aluminium film on a silicon wafer less than 250µm thick including:
(a) placing the wafer on a support;
(b) sputtering a first layer of aluminium onto the substrate with the substrate in an unclamped condition;
(c) clamping the substrate to the support and depositing a second layer of aluminium continuous with the first layer wherein the second layer is thicker than the first layer and the second layer is deposited at a substrate temperature of <22°C.

2. A method as claimed in claim 1 wherein an RF bias is provided to the support during the clamping of the substrate.

3. A method as claimed in claim 2 wherein the RF bias power is between 100 and 500W.

4. A method is claimed in any one of the preceding claims wherein the first layer is 0.5 - 2 µm thick.

5. A method as claimed in claim 4 wherein the second layer is about 7 µm thick.

6. A method as claimed in any one of the preceding claims wherein the thickness ratio of the first layer to the second layer is between 1:3 and 1:15.

7. A method as claimed in any one of the preceding claims wherein the deposition steps occur on different supports.

8. A method as claimed in any one of the preceding claims wherein the deposition steps are performed on the same support.

9. A method as claimed in claim 8 wherein the second deposition step is continuous with the first and is initiated by clamping of the substrate.

10. A method as claimed in any one of the preceding claims where the substrate temperature is <20°C.

11. A method as claimed in any one of the preceding claims wherein the aluminium alloy is Al(Cu, Si (wherein the silicon consists in less than 5%)).

## Patentansprüche

1. Verfahren zum Abscheiden eines Aluminiumfilms auf einem Siliziumwafer, dessen Dicke weniger als 250 µm beträgt, umfassend die folgenden Schritte:
a) Plazieren des Wafers auf einem Träger;
b) Zerstäuben einer ersten Aluminiumschicht auf dem Substrat, wobei sich das Substrat in einem losgelösten Zustand befindet;
c) Festmachen des Substrats an dem Träger und Abscheiden einer zweiten Aluminiumschicht, die in die erste Schicht übergeht, wobei die zweite Schicht dicker ist als die erste Schicht und die zweite Schicht bei einer Temperatur des Substrats von < 22 °C abgeschieden wird.

2. Verfahren nach Anspruch 1, **dadurch gekennzeichnet, daß** an den Träger während des Festmachens des Substrats eine Hochfrequenzspannung angelegt wird.

3. Verfahren nach Anspruch 2, **dadurch gekennzeichnet, daß** der Hochfrequenz-Spannungsstrom zwischen 100 und 500 W beträgt.

4. Verfahren nach einem der vorhergehenden Ansprüche, **dadurch gekennzeichnet, daß** die erste Schicht 0,5 - 2 µm dick ist.

5. Verfahren nach Anspruch 4, **dadurch gekennzeichnet, daß** die zweite Schicht etwa 7 µm dick ist.

6. Verfahren nach einem der vorhergehenden Ansprüche, **dadurch gekennzeichnet, daß** das Dickenverhältnis der ersten Schicht zu der zweiten Schicht zwischen 1 : 3 und 1 : 15 beträgt.

7. Verfahren nach einem der vorhergehenden Ansprüche, **dadurch gekennzeichnet, daß** die Abscheidungsschritte auf unterschiedlichen Trägern vorgenommen werden.

8. Verfahren nach einem der vorhergehenden Ansprüche, **dadurch gekennzeichnet, daß** die Abscheidungsschritte auf demselben Träger vorgenommen werden.

9. Verfahren nach Anspruch 8, **dadurch gekennzeichnet, daß** der zweite Abscheidungsschritt sich an den ersten anschließt und durch Festmachen des Substrats eingeleitet wird.

10. Verfahren nach einem der vorhergehenden Ansprüche, **dadurch gekennzeichnet, daß** die Temperatur des Substrats < 20 °C beträgt.

11. Verfahren nach einem der vorhergehenden Ansprüche, **dadurch gekennzeichnet, daß** die Aluminiumlegierung Al (Cu, Si (wobei das Silizium weniger als 5 % beträgt)) ist.

## Revendications

1. Procédé de dépôt d'un film d'aluminium sur une tranche de silicium de moins de 250 µm d'épaisseur comprenant :
(a) placer la tranche sur un support ;
(b) pulvériser une première couche d'aluminium sur le substrat avec le substrat dans un état non bridé ;
(c) brider le substrat au support et déposer une seconde couche d'aluminium continue avec la première couche, la seconde couche étant plus épaisse que la première couche et la seconde couche étant déposée à une température de substrat de < 22°C.

2. Procédé selon la revendication 1, dans lequel une polarisation RF est appliquée au support durant le bridage du substrat.

3. Procédé selon la revendication 2, dans lequel l'énergie de polarisation RF est entre 100 et 500 W.

4. Procédé selon l'une quelconque des revendications précédentes, dans lequel la première couche est de 0,5 - 2 µm d'épaisseur.

5. Procédé selon la revendication 4, dans lequel la seconde couche est d'environ 7 µm d'épaisseur.

6. Procédé selon l'une quelconque des revendications précédentes, dans lequel le rapport d'épaisseur de la première couche à la seconde couche est entre 1:3 et 1:15.

7. Procédé selon l'une quelconque des revendications précédentes, dans lequel les étapes de dépôt ont lieu sur différents supports.

8. Procédé selon l'une quelconque des revendications précédentes, dans lequel les étapes de dépôt sont réalisées sur le même support.

9. Procédé selon la revendication 8, dans lequel la seconde étape de dépôt est continue avec la première et est initiée par le bridage du substrat.

10. Procédé selon l'une quelconque des revendications précédentes, dans lequel la température de substrat est < 20°C.

11. Procédé selon l'une quelconque des revendications précédentes, dans lequel l'alliage d' aluminium est Al (Cu, Si (le silicium consistant en moins de 5 %)).
